# EUROPEAN PATENT APPLICATION

(11) **EP 2 177 920 A1**
(43) Date of publication of application: **21.04.2010**
(21) Application number: 08172513.7
(22) Date of filing: 22.12.2008
(51) Int. Cl.: G01R 21/133

(54) **Power meter based on system on chip**

(30) Priority: 20.10.2008 KR 20080102743
(71) Applicant: Korea Electric Power Corporation, Seoul (KR)
(72) Inventor: Kim, Young hyn, Daejeon (KR); Myoung, No Gil, Daejeon (KR); Park, Byung Seok, Daejeon (KR); Joo, Sung Ho, Daejeon (KR); Choi, Moon Seok, Daejeon (KR)
(74) Representative: Adamson Jones

(57) **Abstract**

A power meter (100) based on a system-on-a-chip (SoC) is disclosed. The power meter provides all necessary functions related to power metering, power information processing and power information transmission on the basis of a system-on-a-chip enabling power meter functions to be mounted in a single chip in a manner that hardware resources can be recombined to implement hardware logics ensuring portability according to customer needs. The SoC-based power meter includes: an A/D converter (111) converting an analog signal corresponding to a voltage and current supplied to a customer into digital data; a digital signal processor (112) performing power metering by processing digital data from the A/D converter; a micro controller unit (113) processing power meter information using data from the digital signal processor; a memory (114) storing processed power meter information; and interfaces (116,117) sending power meter information stored in the memory to external appliances (140,150), and forwarding signals received from external appliances to the micro controller unit.

## Description

### Background of the Invention

### 1. Field of the Invention

The present invention relates to a power meter based on a system-on-a-chip (SoC).

### 2. Description of the Related Art

A power meter installed in a customer's household measures and records the electric power consumption at the household, and provides metering information related to the measured electric power consumption to the power company according to a metering policy.

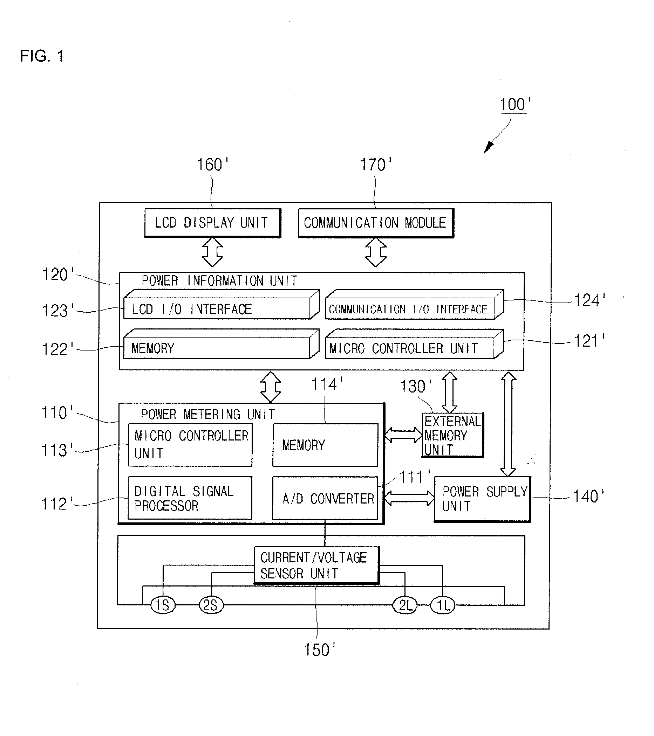

Referring to FIG. 1, a power meter 100' includes a power metering unit 110' operating to acquire power data, a power information unit 120' to process and store the acquired power data and send the processed power data to a power company, and an external memory unit 130'.

To be more specific, the power metering unit 110' includes a high-resolution analog-to-digital converter 111' to convert an analog signal to a digital signal, a digital signal processor 112' to process the digital signal, a micro controller unit (MCU) 113' to process data, and a memory 114' to store the data processed by the micro controller unit 113'.

The power information unit 120' includes a micro controller unit (MCU) 121' to process and manage power data, a memory 122' to store data from the power metering unit 110' and data processed by the micro controller unit 121', an LCD input/output interface 123' to display values for the outside under the control of the micro controller unit 121', and a communication interface 124' to send metering information to the power company. The external memory unit 130', as a separate entity, stores data from the power metering unit 110' and power information unit 120'.

To manufacture the power meter 100', the power metering unit 110', the power information unit 120' and the external memory unit 130' are fabricated as separate modules or chips, and are electrically connected together through wires on a circuit board.

In FIG. 1, a reference symbol 140' refers to a power meter-specific power supply unit supplying power to the power metering unit 110' and power information unit 120'. Reference symbols 150', 160' and 170' refer respectively to a current/voltage sensor unit, LCD display unit, and communication module.

In an existing power meter having the above described configuration, as constituent modules are formed as separate entities, the circuit interconnecting the modules for communication becomes complex and this may cause signal instability.

Further, redundant functions are present in the constituent modules, and it is necessary to develop drivers and application programs to support data transfer therebetween. In particular, massive data generated in the power meter can be systematically managed by organizing various power data acquired from the power metering unit by properties into groups of objects and assigning identification codes to individual objects. However, in the existing power meter, generated data is stored, processed, and transmitted without systematic management. Hence, compatibility may be not ensured between power meters manufactured by different manufacturers, and it may be necessary to discard existing power meters to deploy newly developed power meters. These can cause manufacturing and business costs to increase, and development of power meters to become more difficult.

### Brief Summary of the Invention

The present invention has been made in view of the above problems, and the present invention provides a SoC-based power meter that provides all necessary functions related to power metering, power information processing and power information transmission on the basis of a system-on-a-chip (SoC) enabling power meter functions to be mounted in a single chip instead of multiple chips in a manner that hardware resources can be recombined to implement hardware logics ensuring portability according to customer needs.

The present invention also provides a SoC-based power meter that organizes power data generated in the power metering unit by properties into groups of objects for real-time hardware processing.

The present invention further provides a SoC-based power meter that has a reduced number of components and a simple design and structure so as to be easily developed in a regular SoC development environment.

In accordance with an embodiment of the present invention, there is provided a power meter based on a system-on-a-chip (SoC), including: an analog-to-digital converter converting an analog signal corresponding to a voltage and current supplied to a customer into digital data; a digital signal processor performing power metering by processing the digital data from the analog-to-digital converter; a micro controller unit processing power meter information using data from the digital signal processor; a memory storing the power meter information processed by the micro controller unit; and interfaces sending power meter information stored in the memory to external appliances, and forwarding signals received from external appliances to the micro controller unit, wherein the micro controller unit controls and manages the digital signal processor, memory and interfaces, and additionally classifies the power meter information into objects with common properties, assigns identification numbers to the objects, and stores the power meter information in the memory for management and processing.

The interfaces may be one of a universal asynchronous receiver/transmitter (UART) controller, universal serial bus (USB) controller, Ethernet controller, serial communication controller, infrared communication controller, keypad controller, touch pad controller, and liquid crystal display (LCD) controller.

The analog-to-digital converter, digital signal processor, micro controller unit, memory, and interfaces may be integrated in a single system-on-a-chip.

The objects are configured on the basis of the Object Identification System (OBIS).

OBIS codes for object identification may include a value group A describing data properties, a value group B describing channel numbers, a value group C defining physical quantities, a value group D defining processing results of physical quantities, a value group E describing tariffs, and a value group F describing data times.

The micro controller unit may read, in response to an information request from an external appliance through one of the interfaces, the power meter information in the memory, and send the power meter information in a format conforming to a meter communication protocol to the external appliance.

The meter communication protocol may include a physical layer for media access control, a data link layer for frame structuring, and an application layer supporting packet transmission over the data link layer.

In a feature of the present invention, the SoC-based power meter provides all necessary functions related to power metering, power information processing and power information transmission on the basis of a system-on-a-chip enabling power meter functions to be mounted in a single chip instead of multiple chips in a manner that hardware resources can be recombined to implement hardware logics ensuring portability according to customer needs.

The SoC-based power meter organizes power data generated in the power metering unit by properties into groups of objects for real-time hardware processing.

The SoC-based power meter has a reduced number of components and a simple design and structure, hence it can be easily developed in a regular SoC development environment.

### Brief Description of the Drawings

The features and advantages of the present invention will be more apparent from the following detailed description in conjunction with the accompanying drawings, in which:
FIG. 1 is a block diagram illustrating an existing SoC-based power meter;
FIG. 2 is a block diagram illustrating a SoC-based power meter according to an embodiment of the present invention;
FIG. 3 is a block diagram illustrating a hardware configuration of a system-on-a-chip in the SoC-based power meter;
FIG. 4 illustrates a layered architecture of a system-on-a-chip in the SoC-based power meter;
FIG. 5 illustrates a layered architecture for meter data in the SoC-based power meter;
FIG. 6 illustrates an object identification scheme used in the SoC-based power meter; and
FIGS. 7A and 7B illustrate a list of object identification items used in the SoC-based power meter.

### Detailed Description of the Invention

Hereinafter, embodiments of the present invention are described in detail with reference to the accompanying drawings. The same reference symbols are used throughout the drawings to refer to the same or like parts. Detailed descriptions of well-known functions and structures incorporated herein may be omitted to avoid obscuring the subject matter of the present invention.

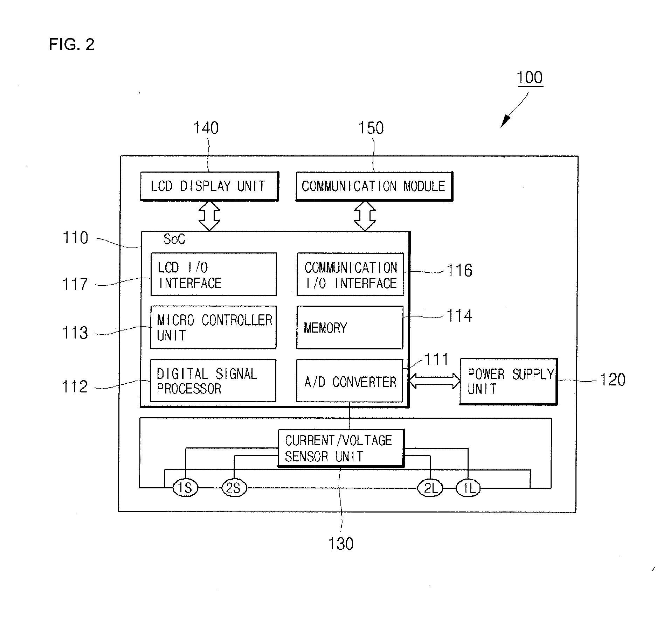

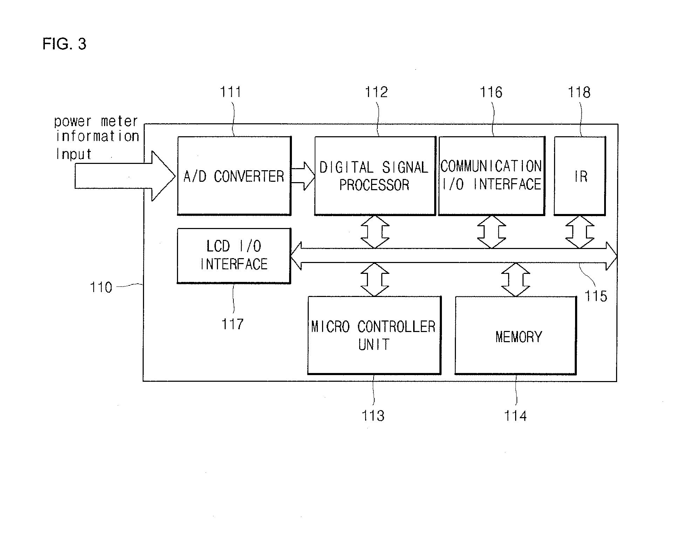

FIG. 2 is a block diagram illustrating a SoC-based power meter 100 according to an embodiment of the present invention. FIG. 3 is a block diagram illustrating a hardware configuration of a system-on-a-chip 110 in the SoC-based power meter 100.

Referring to FIG. 2 and FIG. 3, the SoC-based power meter 100 includes an analog-to-digital converter 111, digital signal processor 112, micro controller unit 113, memory 114, and interfaces 116,117 and 118. The analog-to-digital converter 111, digital signal processor 112, micro controller unit 113, memory 114, and interfaces 116,117 and 118 are all connected to a data bus 115 for data exchange.

A reference symbol 120 refers to a power meter-specific power supply unit; a reference symbol 130 refers to a sensor unit sensing the current and voltage supplied to a customer; and reference symbols 140 and 150 refer respectively to, for example, an LCD display unit and a communication module related to power line or radio frequency communication.

The analog-to-digital converter 111 converts an analog signal from the sensor unit 130, in relation to the voltage and current supplied to the customer, into digital data.

The digital signal processor 112 performs power metering by processing the digital data from the analog-to-digital converter 111. Schemes or algorithms for power metering are known in the art, and a description thereof is omitted.

The micro controller unit 113 processes power meter information using data from the digital signal processor 112. Schemes or algorithms for processing power meter information are known in the art, and a description thereof is omitted.

The memory 114 stores power meter information processed by the micro controller unit 113 in a preset format.

The interfaces 116, 117 and 118 send power meter information stored in the memory 114 to external appliances such as a metering server, and forward signals received from external appliances to the micro controller unit 113.

The interfaces 116, 117 and 118 may be one of a universal asynchronous receiver/transmitter controller, universal serial bus controller, Ethernet controller, serial communication controller, infrared communication controller, keypad controller, touch pad controller, LCD controller, and their equivalents. The interface 116 denotes a communication input/output interface, the interface 117 denotes an LCD input/output interface, and the interface 118 denotes an infrared input/output interface.

The analog-to-digital converter 111, digital signal processor 112, micro controller unit 113, memory 114, and interfaces 116, 117 and 118 are integrated in a single system-on-a-chip 110, and functions related to power metering, power information processing and power information transmission are performed by the system-on-a-chip 110.

The micro controller unit 113 controls and manages the digital signal processor 112, memory 114, and interfaces 116, 117 and 118. The micro controller unit 113 classifies power meter information by properties into groups of objects, assigns identification numbers to objects, and stores the power meter information in the memory 114 for management and processing. This is described in more detail later.

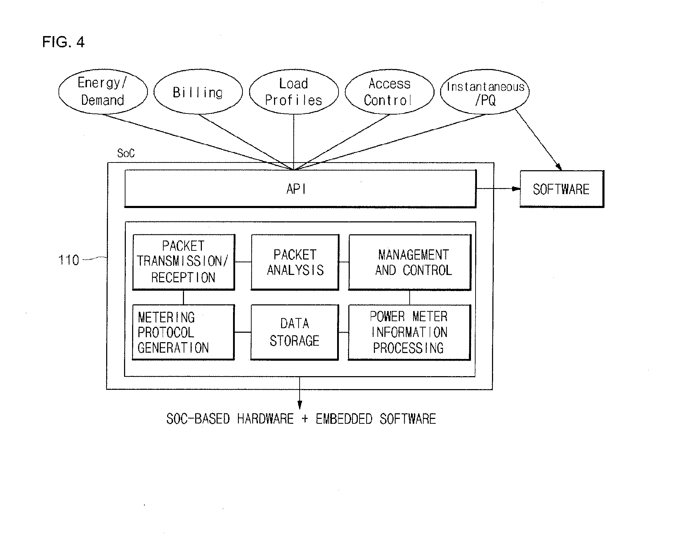

FIG. 4 illustrates a layered architecture of the system-on-a-chip 110 in the SoC-based power meter.

As shown in FIG. 4, power meter information related to Energy/Demand, Billing, Load Profiles, Access Control, and Instantaneous/PQ are handled using an application programming interface (API) and software. The API is used to invoke functions, which are executed by SoC-based hardware and embedded software, related to management and control, power meter information processing, data storage, metering protocol generation, packet transmission and reception, and packet analysis.

Functions related to acquisition, processing, management, transmission and reception, and analysis of power meter information are performed through a hardware processing module in the system-on-a-chip 110, and the processing results are transferred to an application module. A request from an application module is handled by software loaded on a central control module. In addition, an API for accessing entities of power meter information acquired and stored according to a standard data identification scheme is provided to the user, enabling immediate identification of data. When a command is issued through the API to send data to an external appliance (metering server), the hardware processing module creates a packet of a format specified in the Object Identification System (OBIS) and sends the packet to the metering server according to a transmission and reception procedure. The Object Identification System is further described later.

Application modules in the system-on-a-chip 110 are configured on the basis of IEC62056 being a standard specific to meter data exchange. For effective transmission and management of remote meter data, a three-layer architecture is formed to include a physical layer for media access control, a data link layer for frame structuring, and an application layer for packet transmission over the data link layer. This architecture is further described later.

Object definitions necessary for storage and processing of power meter information are described according to IEC 62056-61 and IEC 62056-62, and are based on the Object Identification System. In the Object Identification System, distinct identification codes identify all data entities of power meter information according to classification information including attributes, metered values, set values, and meter operations. The identification codes may have six value groups.

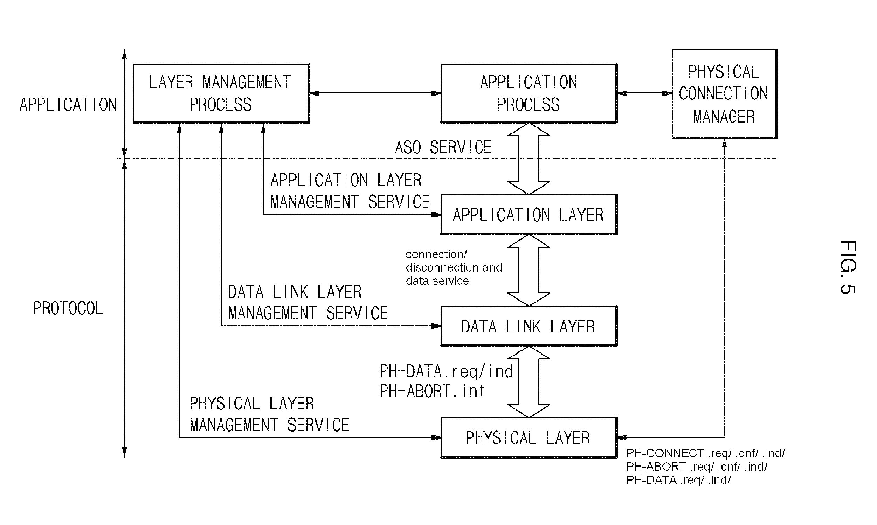

FIG. 5 illustrates a layered architecture for meter data in the SoC-based power meter.

In response to an information request from an external appliance such as a metering server through the interface 116, 117 or 118, the micro controller unit 113 of the SoC-based power meter 100 reads power meter information in the memory 114, and sends the power meter information in a format conforming to a meter communication protocol to the external appliance.

The meter communication protocol is configured to include a physical layer for media access control, a data link layer for frame structuring, and an application layer for supporting packet transmission over the data link layer.

This meter communication protocol is universally applicable to transmission of meter data irrespective of power meter manufacturers. In the meter communication protocol, the physical layer and data link layer cooperates with each other to handle physical layer services related to data request (PH-DATA.request), data indication (PH-DATA.indication), and connection release indication (PH-ABORT.indication). The data link layer and application layer cooperate with each other to provide services related to connection establishment/release and data. The application layer of the protocol and an application process cooperate with each other to provide services related to the Application Service Object (ASO).

The layer management process of the application provides a physical layer management service in cooperation with the physical layer of the meter communication protocol, provides a data link layer management service in cooperation with the data link layer, and provides an application layer management service in cooperation with the application layer.

The physical connection manager of the application and the physical layer cooperate with each other to provide physical layer services related to connection request (PH-CONNECTION.request), connection confirmation (PH-CONNECTION.confirm), connection indication (PH-CONNECTION.indication), connection release request (PH-ABORT.request), connection release confirmation (PH-ABORT.confirm), connection release indication (PH-ABORT.indication), data request (PH-DATA.request), and data indication (PH-DATA.indication).

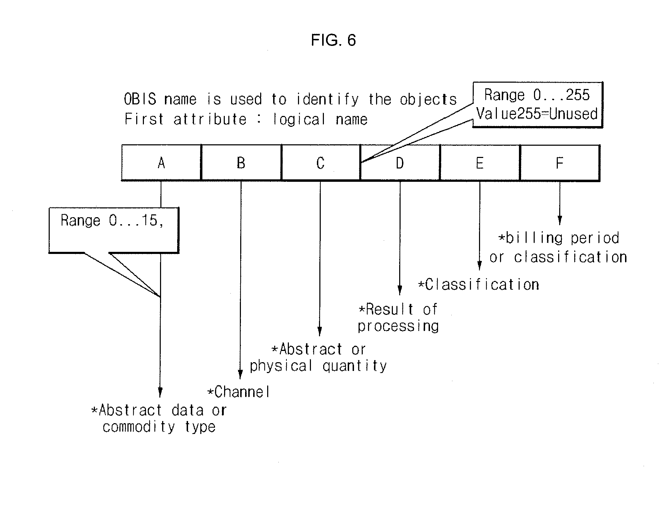

FIG. 6 illustrates an object identification scheme (OBIS) used in the SoC-based power meter.

As shown in FIG. 6, objects, which are processed by the micro controller unit 113 and stored in the memory 114, are organized on the basis of the Object Identification System (OBIS). The OBIS code includes a value group A for describing data properties, a value group B for describing channel numbers, a value group C for defining physical quantities, a value group D for defining processing results of physical quantities, a value group E for describing tariffs, and a value group F for describing data times.

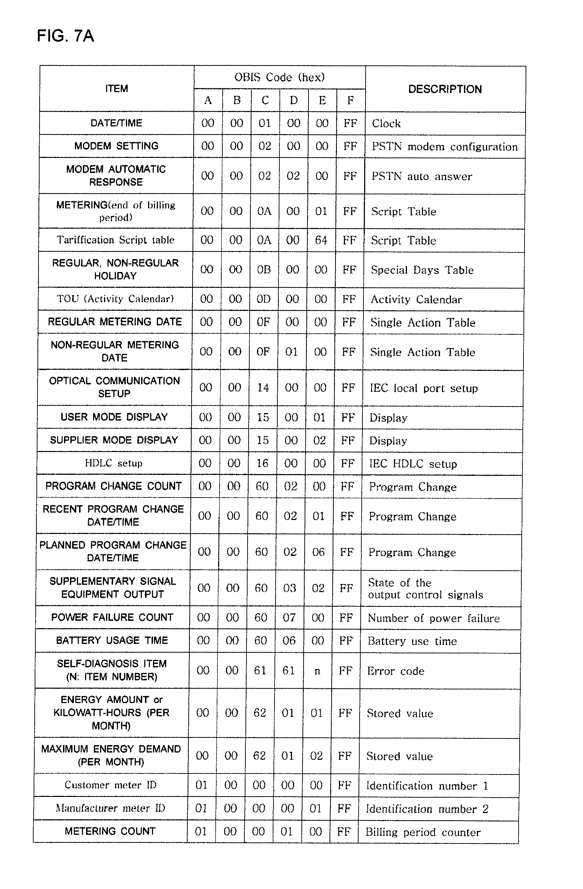

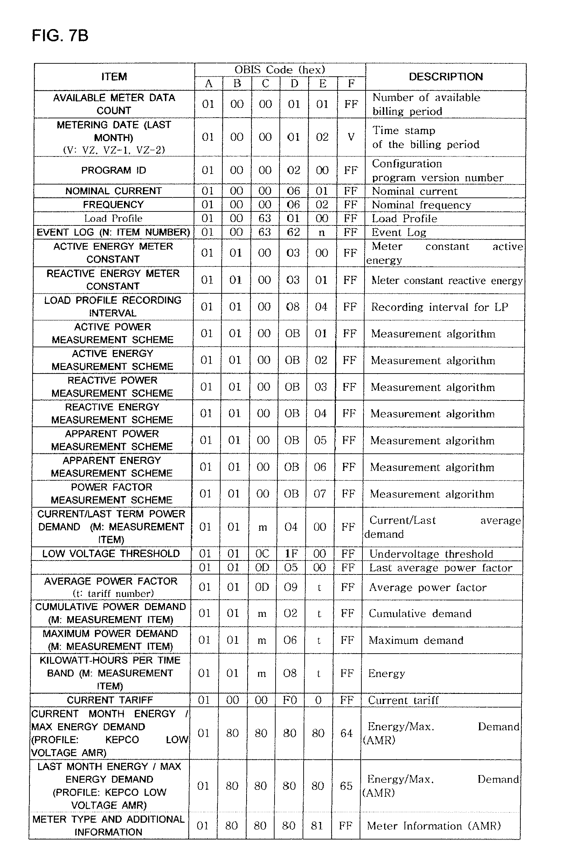

FIGS. 7A and 7B illustrate a list of object identification items used in the SoC-based power meter. For object identification, basic object identification items are formed on the basis of IEC 62056-62 Clause 4.6, and other object identification items are formed with reference to FIGS. 7A and 7B.

As described above, the main components of the SoC-based power meter of the present invention are integrated in a system-on-a-chip through a single semiconductor process. Hence, the SoC-based power meter can be manufactured at low costs, operate at low power, and have a small size. The SoC-based power meter can also reduce the number of components, contribute to reduction of development time, and be easily embedded in an apparatus. Further, power meter information is organized by objects with common properties, and can be processed in real time by hardware, thereby ensuring data compatibility and ease of implementation.

Although the embodiments of the present invention have been described in detail hereinabove, it should be understood that many variations and modifications of the basic inventive concept herein described will still fall within the spirit and scope of the present invention as defined in the appended claims.

## Claims

1. A power meter based on a system-on-a-chip (SoC), comprising:
an analog-to-digital converter converting an analog signal corresponding to a voltage and current supplied to a customer into digital data;
a digital signal processor performing power metering by processing the digital data from the analog-to-digital converter;
a micro controller unit processing power meter information using data from the digital signal processor;
a memory storing the power meter information processed by the micro controller unit; and
interfaces sending power meter information stored in the memory to external appliances, and forwarding signals received from external appliances to the micro controller unit,
wherein the micro controller unit controls and manages the digital signal processor, memory and interfaces, and additionally classifies the power meter information into objects with common properties, assigns identification numbers to the objects, and stores the power meter information in the memory for management and processing.

2. The power meter of claim 1, wherein the interfaces are one of a universal asynchronous receiver/transmitter (UART) controller, universal serial bus (USB) controller, Ethernet controller, serial communication controller, infrared communication controller, keypad controller, touch pad controller, and liquid crystal display (LCD) controller.

3. The power meter of claim 1, wherein the analog-to-digital converter, digital signal processor, micro controller unit, memory, and interfaces are integrated in a single system-on-a-chip.

4. The power meter of claim 1, wherein the objects are configured on the basis of the Object Identification System (OBIS).

5. The power meter of claim 4, wherein OBIS codes for object identification comprise a value group A describing data properties, a value group B describing channel numbers, a value group C defining physical quantities, a value group D defining processing results of physical quantities, a value group E describing tariffs, and a value group F describing data times.

6. The power meter of claim 1, wherein the micro controller unit reads, in response to an information request from an external appliance through one of the interfaces, the power meter information in the memory, and sends the power meter information in a format conforming to a meter communication protocol to the external appliance.

7. The power meter of claim 6, wherein the meter communication protocol comprises a physical layer for media access control, a data link layer for frame structuring, and an application layer supporting packet transmission over the data link layer.
